# EUROPEAN PATENT APPLICATION

(11) **EP 1 598 861 A1**
(43) Date of publication of application: **23.11.2005**
(21) Application number: 04291304.6
(22) Date of filing: 19.05.2004
(51) Int. Cl.: H01L 21/52, H05K 13/08, H05K 13/04

(54) **Method and machine for calibrating and controlling the embedding process in the manufacturing of chip cards**

(71) Applicant: Axalto S.A., 92120 Montrouge (FR)
(72) Inventor: Ros, Frédéric, 92120 Montrouge (FR); Gonzalez, Maria, 92120 Montrouge (FR); Chardon, Joseph, 92120 Montrouge (FR)

(57) **Abstract**

The machine includes a XY-table (50) provided with a card holder adapted to receive a card body (10) wherein orthogonal edges of the card body are applied against corresponding reference surfaces (46,48) of the card holder. The XY-table issues position signals (Pos (X,Y)) related to the current relative position of the card holder. A viewing device (58) forms an image of a portion of the card and issues co-ordinate signals (V(X,Y)) representative of the position of at least one target point on the card body. The viewing device (58) is adapted to form a blown-up image with a field of view including the outline of the cavity but not including the edges of the card body. The machine further includes calibrating means which receive co-ordinate signals (V(X,Y)) issued by the viewing device from an image of a master reference card bearing at least one reference target point having a known predefined position and which determine a conversion function between co-ordinate signals (V(X,Y)) issued by the viewing device and corresponding position signals (Pos(X,Y)) issued by the XY-table. Thus the machine may directly provide positional and/or dimensional data related to a cavity of a card body thereafter placed on the XY-table without viewing the edges of said card body.

## Description

### BACKGROUND OF THE INVENTION

### Field of the invention

The present invention generally relates to the manufacturing of chip cards, in particular the control of the step in which a chip module is embedded into a recess milled in a card body.

### Background art

In a process for manufacturing chip cards, first a card body is produced from several individual layers of plastic foils laminated together, the card body being cut out to a rectangular shape the dimensions of which are specified according to given standards, in particular according to chip card standard ISO 7816-1 (length 85.6 ± 0.13 mm; width 53.98 ± 0.06 mm). After the blank card body is obtained, a cavity or recess must be milled out to hold the chip module. The size and position of this recess should be adapted to the geometry and position of the chip module, which is also specified by ISO standards, specifically ISO 7816-2 which defines the position of the contacts of the chip with respect to the nearest orthogonal edges of the card body. In order to manage with manufacturing tolerances, the dimensions of the recess should be slightly larger than the dimensions of the chip module. Consequently, once the chip module has been embedded in the card body, there remains around the chip module a so-called "white edging" aspect, namely a gap between the module and the cavity edges.

There has been recently more and more stringent requirements to reduce the white edging in certain implementations, for instance in the banking field. However reduction of the white edging imposes a very strict matching between the milling machine, which forms the recess, and the embedding machine, which puts the module into this recess. These machines operate independently, a batch of card bodies made by a milling machine being at a later stage placed in the embedding machine for insertion of the chip module.

So far, it is possible to get good results with respect to the reduction of the white edging when milling machines and embedding machines are adjusted in respective pairs, namely when one particular milling machine serves only for one embedding machine. It is in this case relatively easy to manually adapt and tune up the two machines to get a sufficient repeatability. However, when several machines are used in the same workshop, adjustment becomes much more difficult and time-consuming, so these machines are generally just matched by milling/embedding pairs. The drawback is that there is no possibility to optimize the overall manufacturing process, for instance when there is a malfunction of one of the machines, or when one of the machines should be serviced- then the other machine of the matched pair should be stopped.

For the adjustment of the machines, a precise measurement of the dimensions and position of the recess is necessary. Such a measurement is generally obtained by the use of a video projector.

There exists video projectors which project the image of the object to be viewed, namely of the recess formed in the card body, to an operator, who can check through a visual inspection whether there is a defect in the shape of the cavity which has been milled, for instance by superimposing a reference mask on the image.

However, in order not only to view the recess, but to perform the measurement of the position and dimensions of said recess, the card body is placed on a XY-table provided with a card holder, which may be operated to translate the card body, so as to provide dimensional data from the displacements of the XY-table with respect to predetermined references. Nevertheless, the displacements of the XY-table remain controlled by the operator from a visual inspection or the image formed by the camera, hence subject to errors and dependent on the skill of the operator.

There exist more sophisticated systems in which the XY-table is moved automatically under control of signals resulting from an automatic analysis of the image, performed through complicated algorithms applied to each image captured. These systems may give precise results, however their implementation is very time-consuming. Further, in order to obtain accurate measurements, the field of the camera has to be the smallest possible (high magnification factor), and it is necessary to move and stop the camera to capture and process images of a series of individual areas. Typically, the measurement time is longer than 30 s per item, which is not compatible with an industrial process with high throughput. Further, since only partial images are displayed at a row, this is somewhat disturbing for the production operators who are used to view on their screens the whole image of the recess, so they generally consider that this partial images incorporate no relevant information useful for a routine control.

### SUMMARY OF THE INVENTION

It is therefore an object of the invention to provide a method and a machine for calibrating and controlling a manufacturing process in which an embedding machine may receive cards obtained from any milling machine among a plurality of machines, so that there is no need to match the milling and the embedding machines.

Accordingly, it will be possible to increase the throughput of the whole manufacturing process by making the respective machines operating independently from each other.

A further object of the invention is to simplify and make more precise the calibration and the control of the machines, therefore improving repeatability and quality of production, in particular by reducing the "white edging" to a minimum.

The method set forth by the invention is of the above-related type, including: operating a XY-table provided with a card holder adapted to receive a card body wherein orthogonal edges of said card body are applied against corresponding reference surfaces of said card holder, to issue position signals related to the current relative position of the card holder; and operating a viewing device to form an image of a portion of the card body across a given field of view, and to issue co-ordinate signals representative of the position of at least one target point on the card body with respect to said orthogonal edges of the card body.

According to the invention, the method further includes the steps of: operating the viewing device to form a blown-up image of the card body in which said field of view includes the outline of the cavity but does not include the edges of the card body; receiving co-ordinate signals issued by the viewing device from an image of a master reference card, said master reference card bearing at least one reference target point having a known predefined position with respect to the edges of said master reference card; and determining a conversion function between co-ordinate signals issued by the viewing device and corresponding position signals issued by the XY-table.

This method enables to directly provide positional and/or dimensional data related to a cavity of a card body thereafter placed on the XY-table without viewing the edges of said card body.

The present invention also sets forth a machine for implementing the above-mentioned method, along with a master reference card for implementing said method or for use in combination with such a machine.

Specifically, the master reference card according to the invention comprises a substrate the shape and dimensions of which comply with chip card standards, and bearing on its upper surface a predetermined visible pattern including said at least one reference target point.

The pattern is preferably located on the substrate with it centre substantially located at the central position of the recess as prescribed by chip card standards. The material of the substrate is preferably glass, the pattern being an engraved pattern. The predetermined pattern of the master reference card advantageously includes a series of concentric figures, such as rectangles or squares which sizes are parallel to the edges of the substrate; the pattern may further include two orthogonal lines parallel to the respective edges of the substrate.

### BRIEF DESCRIPTION OF THE DRAWINGS

The foregoing and other objects, aspects and advantages of the invention will be better understood from the following detailed description of a preferred embodiment of the invention made with reference to the drawings, in which:
Figure 1 is a schematic illustration of the parts of the card involved in the embedding process;
Figure 2 illustrates the chip module after it has been embedded in the recess of the card body, showing the gap remaining between the edges of the module and the edges of the recess;
Figure 3 illustrates the field of view of a camera as used in the known techniques;
Figure 4 illustrates the non-optimized process according to the prior art.
Figure 5 illustrates the field of view of the camera as used in the present invention;
Figure 6 is a schematic view of the camera and of the XY-table used in the method of the invention;
Figure 7 illustrates the glass card used as a master reference card in the method of the invention;
Figure 8 illustrates the combination of information enabling a precise determination of the position and size of the recess thanks to the method of the invention;
Figure 9 illustrates the optimized process permitted by the use of the method according to the invention;
Figure 10 is a flow-chart of the main steps in a quality control task according to the teachings of the invention.

### DETAILED DESCRIPTION OF A PREFERRED EMBODIMENT OF THE INVENTION

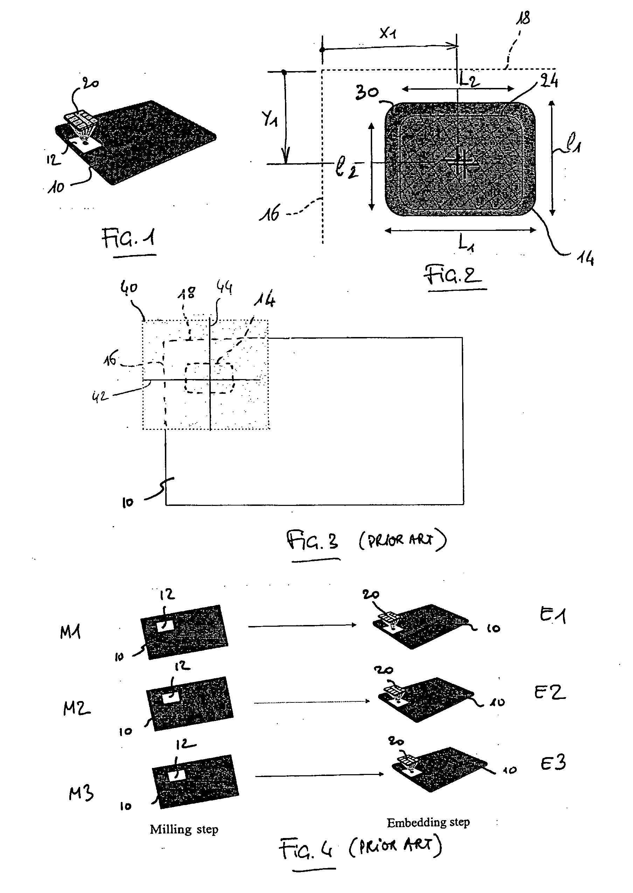

Referring now to the drawings, Figure 1 generally illustrates a chip card, which is comprised of a card body 10 in which a recess (or "cavity") 12 has been milled out for receiving a chip module 20. In the manufacturing process for such a card are provided two steps called "milling" and "embedding" (or "insertion"). The milling step consists in forming the recess or cavity 12 from the card body 10, while the insertion step consists in integrating the module on the card by putting a drop of glue at the centre of the recess 12, placing the chip module 20 over this recess, then pressing the chip module in order to include it in the recess, thus providing a finished blank card ready for printing, embossing, chip programming, etc.

In order to obtain a good insertion of the chip module 20 into the recess 12, this recess must be milled at the right position and with the right dimensions.

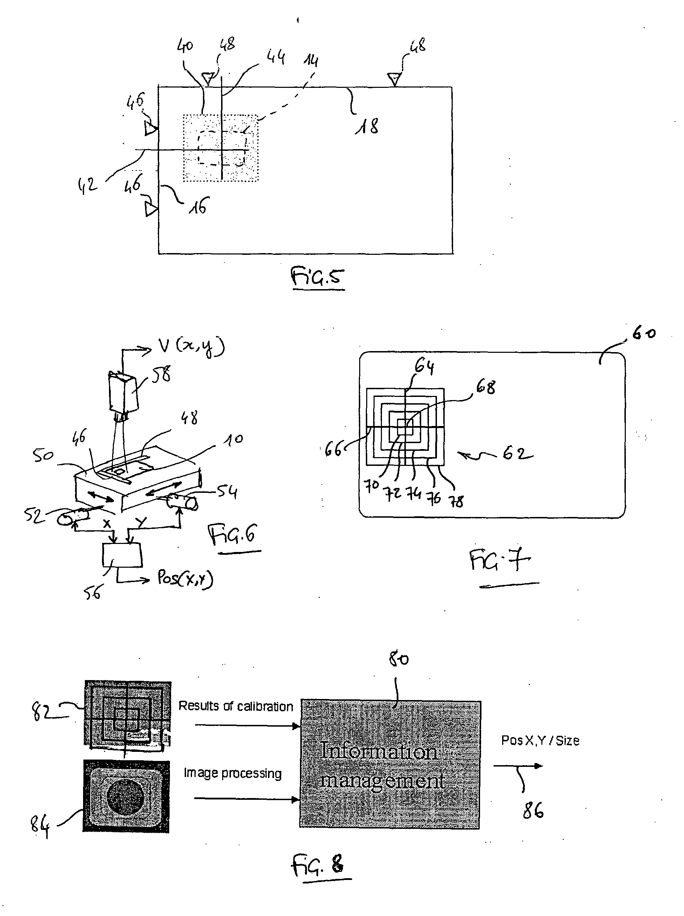

A good insertion is achieved when the chip module is placed in the recess 12 with a minimum gap between the module and the recess. More specifically, as shown on Figure 2, in order to cope with unavoidable tolerances, dimensions L₁ and I₁ of the recess should be somewhat larger than corresponding dimensions L₂ and I₂ of the chip module, therefore leaving a gap 30 between the peripheral outline 14 of the recess and the peripheral outline 24 of the module.

Improvement of final quality of the product requires a reduction of this gap 30 (which is filled by the overflow of the glue when the chip module is pressed into the recess). This aspect, which is called "white edging", should be reduced to a minimum, otherwise the visual aspect of the card will be poor; further, in some applications such as for banking cards, the applicable requirements impose very stringent tolerances with respect to this point.

Also critical is the position of the recess, as determined by co-ordinates X₁ and Y₁ defined with respect to the corresponding edges 16 and 18 of the card, which must meet ISO standards upon the position of the contacts of the chip, which determine the position of the central point of the chip module.

Once a card body has undergone milling of the cavity, it is possible to proceed with the measurements of parameters L₁, I₁, X₁ and Y₁ by means of viewing machines adapted to form and image of the area of the recess and of the portion of the card incorporating the card edges located in the vicinity thereof.

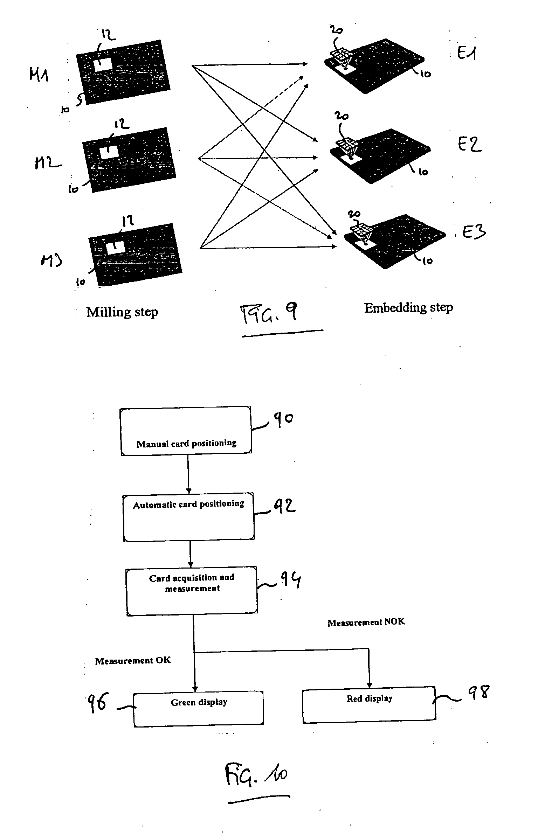

This is shown on Figure 3, in which reference 14 designates the camera field across which the outline 14 of the recess can be viewed, simultaneously with the corresponding edges 16 and 18 of the card. References 42 and 44 designate the reference axes of the image of the camera, which form a collimator enabling the operator to visually determine the centre of the cavity by translating and XY-table supporting the card into orthogonal directions in order to determine co-ordinate values X₁ and Y₁. Through the same process, it is also possible to determine dimensions L₁ and I₁ of the recess.

As explained above, this way of controlling the geometry of the cavity obtained after the milling step is very long to implement, even if the displacements of the XY-table are controlled automatically in response to suitable image analysis algorithms.

Further, the necessity to include in the field of view 40 of the camera both the outline 14 of the cavity and the edges 16, 18 of the card at the same time imposes a rather low magnification factor, leading to a somewhat poor precision in the measurement.

For these reasons, so far this measurement test has just been applied to samples of card bodies after milling for quality control, but never to a substantial proportion of cards produced, before transferring them to the embedding machines.

Further, and more importantly, since the measurements are not accurate enough, and cannot be performed on a comprehensive basis, when involving several milling machines and several embedding machines the manufacturing process could not be fully optimized. More specifically, as shown on Figure 4, every milling machine M1, M2, M3, ... should be matched to a corresponding embedding machine E1, E2, E3 ... in pairs (M1,E1), (M2,E2), (M3,E3), ... with, for each pair, one of the machine being specifically tuned up to the particulars of the other machine, in order to ensure repeatability and a sufficient precision in the manufacturing process.

In order to mitigate these drawbacks, the invention basically proposes to combine a sophisticated mechanical card positioning procedure involving a viewing device equipped with a camera combined with an XY-table, and a specific preliminary training procedure enabling to calibrate the viewing device, and at the same time analyse the geometry of the card, by means of a master reference card (hereafter "glass card") bearing some known and easily recognizable patterns engraved on its surface and serving as a reference for calibration.

As will be explained below, this further allows a substantial reduction of the field of view of the camera: as shown on Figure 5, this field of view 40 can be reduced to a size which is just slightly wider than the dimensions of the outline 40 of the recess, however which does not include the edges 16,18 of a card body. For instance, this field of view 40 may have a size of 20 x 20 mm, which is about twice smaller than the field of view which would be necessary if one would require to view the card edges 16,18 on the same image, as in Figure 3. This field may be even more reduced, depending on the specific size of the cavity milled in the process concerned.

Figure 6 generally illustrates the machine used in implementing the invention.

The card body 10 to be inspected is abutted against two orthogonal reference surfaces 46, 48 of a card holder of an XY-table 50. The XY-table is movable in two orthogonal directions parallel to the directions of the references surfaces 36, 48 by means of two stepper motors 52, 54 which are driven by a control unit 56. Control unit 56 issues a position signal Pos(X,Y) which is representative of the relative position of the XY-table 50 in the two orthogonal directions.

A camera 58 is fixedly positioned over the XY-table 50, namely the XY-table may move with respect to the camera. However it is possible, conversely, to provide a movable camera mounted on an XY-stand positioned over a fixed table supporting the card holder.

Camera 58 produces video signals which are processed to issue co-ordinate signals V (X,Y) representative of the position of a given point (namely a given pixel) of the image, for instance of the central point viewed on the operator's screen.

Since (i) the field of view no longer includes the edges of the card, and (ii) the position signals issued by control unit 56 only give a representation of the relative displacements of the XY-table, it is necessary to modelize the edges of the card. This modelization is done by a preliminary training step, from a master reference card of known dimensions bearing finely engraved patterns.

Figure 7 illustrates such a reference card 60, which is preferably made of glass, so this card may be termed "glass card". Use of glass enables printing or engraving of a high precision reference pattern 62 formed from very narrow lines or strips of precise size. The position and the dimensions of the lines of pattern 62 have been previously measured by known specific procedures and are therefore known with a very high degree of precision, so the pattern is completely characterized with high accuracy in terms of shape and position (distances to card edges), typically an accuracy of at least 2 µm.

Pattern 62 includes for instance orthogonal axes 64, 66 which are parallel to the edges of the card and defines a centre point 68 corresponding to the centre point of the chip contacts as specified by ISO standards. Patent 62 also includes a series of concentric figures 70, 72, 73, 74, 76, 78, preferably evenly spaced concentric squares, that will be used for precisely calibrating the magnification factor of camera 58 through comparison between the size of the image viewed and the actual, known size of the squares.

When the glass card 60 is positioned in the card holder of the XY-table 50, the camera may be calibrated, namely a relation between position signals Pos(X,Y) issued by control unit 56 and co-ordinate signals V(X,Y) issued by camera 58 may be defined. In other words, an information related to the physical position of the XY-table, issued by control unit 56, is associated to image information (pixel units) issued by camera 58. It becomes therefore possible, from the co-ordinate signal V(X,Y) issued by camera 58 alone, to derive an information about the actual position of a target point on the card with respect to the edges of said card, though the edges of the latter are not visible and not viewed by the camera.

This procedure also allows to take into account small rotation errors between camera 58 and XY-table 50, namely to compensate for the case when e. g. lines 64, 66 would not be exactly vertical and horizontal on the image as viewed by the camera.

As shown on Figure 8, from the results of the calibration obtained through use of the glass card (image 82) the camera may be calibrated and the position of the edges, namely the position of the reference surfaces 46, 48 of the card holder, may be defined (modelized) in the camera co-ordinate reference. Then, during the production phase a card with a milled recess is placed on the card holder of the XY-table under camera 58, with the same mechanical and pressure adjustments as for the glass card, resulting in an image (image 84) obtained under the same conditions as the glass card. Thanks to the co-ordinate references that have been stored during the training phase, the information management system 80 may issue, through suitable, known image processing algorithms, data 86 related to the dimensions of the (viewed) cavity, and also to the position of this cavity with respect to the (not viewed) edges of the card body under test.

This enables, as shown on Figure 9, an optimization of the manufacturing process by making it possible to load any of the embedding machines E1, E2, E3 ... with a batch of cards in which a cavity has been milled by any of the milling machines M1, M2, M3 ...

Such an optimization is made possible by tuning the machines via a common system making use of the calibrating and controlling method of the invention; it is enough to test one sample card in a batch of cards produced by a given milling machine in order to correspondingly tune in the embedding machine with respect to the cards of this batch.

The method of the invention may also be used in a quality control step, for instance for checking that the milling machines that have been tuned produce card bodies that comply with the initial tuning, with no bias or drift.

This can be done simply by taking out a sample card body in a given batch and following the tasks shown in Figure 10: according to this procedure, the card to be tested is placed in the card holder of the XY-table 50, manually and/or automatically (steps 90, 92). Then the card is measured (step 94) namely an image as the image 84 of Figure 8 is obtained and processed by the information management system 80, giving information about the dimensions of the recess and its position with respect to orthogonal edges of the card. If the results lie within the tolerances required (step 96) then the process may continue, otherwise (step 98) the process should be interrupted and the tuning of the embedding machine should be modified in order to conform to the parameters that have changed.

## Claims

1. A method for calibrating and controlling a manufacturing process in which a recess (12) is milled in a card body (10) then a chip module (20) is fed and embedded into said recess for providing a chip card, said method including:
- operating a XY-table (50) provided with a card holder adapted to receive a card body (10) wherein orthogonal edges (16,18) of said card body are applied against corresponding reference surfaces (46,48) of said card holder, to issue position signals (Pos(X,Y)) related to the current relative position of the card holder; and
- operating a viewing device (58) to form an image of a portion of the card body across a given field of view (40), and to issue co-ordinate signals (V(X,Y)) representative of the position of at least one target point on the card body with respect to said orthogonal edges (16,18) of the card body,
wherein said method is **characterised by** the steps of:
- operating the viewing device to form a blown-up image of the card body in which said field of view (40) includes the outline of the cavity but does not include the edges of the card body;
- receiving co-ordinate signals (V(X,Y)) issued by the viewing device from an image of a master reference card (60), said master reference card bearing at least one reference target point (68) having a known predefined position with respect to the edges of said master reference card; and
- determining a conversion function between co-ordinate signals (V(X,Y)) issued by the viewing device and corresponding position signals issued by the XY-table,
whereby directly providing positional and/or dimensional data related to a cavity of a card body thereafter placed on the XY-table without viewing the edges of said card body.

2. A machine for calibrating and controlling a manufacturing process in which a recess (12) is milled in a card body (10) then a chip module (20) is fed and embedded into said recess for providing a chip card, said machine including:
- a XY-table (50) provided with a card holder adapted to receive a card body (10) wherein orthogonal edges (16,18) of said card body are applied against corresponding reference surfaces (46,48) of said card holder, said XY-table being adapted to issue position signals (Pos (X,Y)) related to the current relative position of the card holder,
- a viewing device (58), adapted to form an image of a portion of the card body across a given field of view (40), and to issue co-ordinate signals (V(X,Y)) representative of the position of at least one target point on the card body with respect to said orthogonal edges (16,18) of the card body,
wherein said machine is **characterised in that**:
- said viewing device (58) is adapted to form a blown-up image of the card body in which said field of view (40) includes the outline of the cavity but does not include the edges of the card body;
- the machine includes calibrating means, adapted to:
· receive co-ordinate signals (V(X,Y)) issued by the viewing device from an image of a master reference card (60), said master reference card bearing at least one reference target point (68) having a known predefined position with respect to the edges of said master reference card, and
· determine a conversion function between co-ordinate signals (V(X,Y)) issued by the viewing device and corresponding position signals (Pos(X,Y)) issued by the XY-table,
whereby said machine is operable to directly provide positional and/or dimensional data related to a cavity of a card body thereafter placed on the XY-table without viewing the edges of said card body.

3. A master reference card for implementing the method of claim 1 or for use in combination with a machine according to claim 2, **characterised by** comprising a substrate (60) the shape and dimensions of which comply with chip card standards, and bearing on its upper surface a predetermined visible pattern (62) including said at least one reference target point (68).

4. The master reference card of claim 3, wherein said pattern (62) is located on the substrate with its centre (68) substantially located at the central position of the recess as prescribed by chip card standards.

5. The master reference card of claim 3, wherein the material of said substrate is glass, and said pattern (62) is an engraved pattern.

6. The master reference card of claim 3, wherein said predetermined pattern (62) includes a series of concentric figures (70-78).

7. The master reference card of claim 6, wherein said concentric figures (70-78) are rectangles or squares which sides are parallel to the edges of the substrate.

8. The master reference card of claim 3, wherein said predetermined pattern (62) includes two orthogonal lines (64, 66) parallel to the respective edges of the substrate.
